# EUROPEAN PATENT APPLICATION

(11) **EP 4 752 923 A1**
(43) Date of publication of application: **03.06.2026**
(21) Application number: 25219031.9
(22) Date of filing: 27.11.2025
(51) Int. Cl.: H01H 9/54, H01H 71/12, H01H 71/46

(54) **SOLID-STATE CIRCUIT BREAKER**

(30) Priority: 29.11.2024 CN 202411732612
(71) Applicant: SCHNEIDER ELECTRIC INDUSTRIES SAS, 92500 Rueil-Malmaison (FR)
(72) Inventor: BAI, Wanlong, Shanghai, 201203 (CN); LI, Xiaoqiang, Shanghai, 201203 (CN); SHUANG, Bing, Shanghai, 201203 (CN); YING, Xiaoping, Shanghai, 201203 (CN)
(74) Representative: Openshaw & Co.

(57) **Abstract**

A solid-state circuit breaker (100) includes an electronic switch (170); a mechanical switch (110) configured to complete a turn-on process and a turn-off process by manual operation; and a sensor (120, 130, 140) configured to generate a trigger signal depending on a position of the mechanical switch (110) during at least one of the turn-on process or the turn-off process. A control unit (150) is configured to activate a boosting mechanism (160) according to the trigger signal. The boosting mechanism (160) is configured to provide a boost for the turn-on process or the turn-off process. The electronic switch (170) is connected in series with the mechanical switch (110).

## Description

### TECHNICAL FIELD

The present invention relates to a solid-state circuit breaker.

### BACKGROUND

Solid-state circuit breakers are currently becoming more and more widespread. The solid-state circuit breaker can be constructed as a solid-state hybrid control system. For solid-state hybrid control systems, human operating space is usually required at the isolation mechanism, i.e., the mechanical switch. Operators rotate, push and pull actions to open or close the mechanical switch. Because each operator has inconsistent operating habits or different forces, operators usually exhibit different operating behaviors during the turn-off process or the closing process.

In order to ensure the consistency of human operation of the isolation mechanism and to ensure the operator's experience, it is necessary to design a new type of solid-state circuit breaker.

### SUMMARY

The present disclosure provides a solid-state circuit breaker with a boosting mechanical switch. The solid-state circuit breaker according to the present disclosure can provide an operator with assistance or boosting when the operator manually turns on and off the mechanical switch therein, thereby ensuring the consistency of the operator's action behavior and avoiding the occurrence of an intermediate state between turn on and turn off.

The present disclosure provides a solid-state circuit breaker comprising: an electronic switch; a mechanical switch configured to complete a turn-on process and a turn-off process by manual operation; a sensor configured to generate a trigger signal depending on a position of the mechanical switch during the turn-on process or the turn-off process; a control unit configured to activate a boosting mechanism according to the trigger signal; and the boosting mechanism configured to provide a boost for the turn-on process or the turn-off process; wherein the electronic switch is connected in series with the mechanical switch.

In an embodiment according to the present disclosure, the mechanical switch starts from an off position through a turn-on process mid position to an on position; the sensor comprises a first sensor; the first sensor is configured to generate a first trigger signal in response to the mechanical switch reaching the turn-on process mid position; and the control unit is configured to activate the boosting mechanism according to the first trigger signal.

In an embodiment according to the present disclosure, the mechanical switch starts from the on position through a turn-off process mid position to the off position; the sensor comprises a second sensor; the second sensor is configured to generate a second trigger signal in response to the mechanical switch reaching the turn-off process mid position; and the control unit is configured to activate the boosting mechanism according to the second trigger signal.

In an embodiment according to the present disclosure, the control unit is configured to control the turn-off of the electronic switch according to the second trigger signal and activate the boosting mechanism after a predetermined time interval.

In an embodiment according to the present disclosure, controlling the turn-off of the electronic switch according to the second trigger signal includes: sending a turn-off signal to the electronic switch according to the second trigger signal, and detecting whether the electronic switch is successfully turned off; and activating the boosting mechanism after a predetermined time interval includes: activating the boosting mechanism after a predetermined time interval in response to the electronic switch being successfully turned off.

In an embodiment according to the present disclosure, the mechanical switch is configured as a depressible knob; the sensor comprises a third sensor; the third sensor is configured to generate a third trigger signal in response to the mechanical switch being depressed; and the control unit is configured to activate the boosting mechanism according to the first trigger signal and the third trigger signal.

In an embodiment according to the present disclosure, the first sensor is configured as a first micro-switch; the first sensor generating a first trigger signal in response to the mechanical switch reaching the turn-on process mid position includes: the first micro switch generating the first trigger signal in response to the mechanical switch moving away from the off position.

In an embodiment according to the present disclosure, the second sensor is configured as a second micro switch; the second sensor generating a second trigger signal in response to the mechanical switch reaching the turn-off process mid position includes: the second micro switch generating the second trigger signal in response to the mechanical switch moving away from the on position.

In an embodiment according to the present disclosure, the predetermined time interval is set in the range of 3 ms to 10 ms.

In an embodiment according to the present disclosure, the boosting mechanism is designed as an electromagnetic boosting mechanism comprising: a coil and an iron core; the iron core is linked with the mechanical switch; the control unit is configured to control the direction of current flowing through the coil depending on the trigger signal; and the iron core provides a boost to the turn-on process in response to a positive current flowing in the coil, and provides a boost to the turn-off process in response to a negative current flowing in the coil..

In an embodiment according to the present disclosure, the mechanical switch includes a manual operating component, a transmission component, a movable contact and a stationary contact.

### BRIEF DESCRIPTION OF DRAWINGS

In order to explain the technical solutions of the embodiments of the present disclosure more clearly, the drawings needed to be used in the description of the embodiments will be briefly introduced below. Obviously, the drawings in the following description are only some exemplary embodiments of the present disclosure. For those of ordinary skill in the art, other embodiments can be obtained based on these embodiments without exerting creative efforts.
Fig. 1 schematically illustrates a circuit diagram of a solid-state circuit breaker according to an embodiment of the present disclosure,
Fig. 2 schematically illustrates the turn-on process of a mechanical switch configured as a knob in a solid-state circuit breaker according to an embodiment of the present disclosure,
Fig. 3 schematically illustrates the turn-off process of a mechanical switch configured as a knob in a solid-state circuit breaker according to an embodiment of the present disclosure,
Fig. 4 schematically illustrates a timing diagram of the turn-on process of a solid-state circuit breaker according to an embodiment of the present disclosure,
Fig. 5 schematically illustrates a timing diagram of the turn-off process of a solid-state circuit breaker according to an embodiment of the present disclosure, and
Fig. 6 schematically illustrates a structural diagram of a mechanical switch and a boosting mechanism in a solid-state circuit breaker according to an embodiment of the present disclosure.

### DETAILED DESCRIPTION

In order to make the purpose, technical solutions and advantages of the present disclosure more obvious, example embodiments according to the present disclosure will be described in detail below with reference to the accompanying drawings. Obviously, the described embodiments are only some of the embodiments of the present disclosure, but not all of the embodiments of the present disclosure. It should be understood that the present disclosure is not limited by the example embodiments described here.

In this specification and the drawings, substantially the same or similar steps and elements are denoted by the same or similar reference numerals, and repeated descriptions of these steps and elements will be omitted. Meanwhile, in the description of the present disclosure, the terms "first", "second", etc. are only used to distinguish descriptions and cannot be understood as indicating or implying relative importance or ranking.

In this specification and the drawings, elements are described in singular or plural forms according to embodiments. However, the singular and plural forms are appropriately selected for the proposed cases merely for convenience of explanation and are not intended to limit the present disclosure thereto. Thus, the singular can include the plural, and plural can also include the singular, unless the context clearly indicates otherwise. In the embodiments of the present disclosure, unless otherwise expressly stated, "connected" does not mean "directly connected" or "directly in contact", but only requires electrical communication.

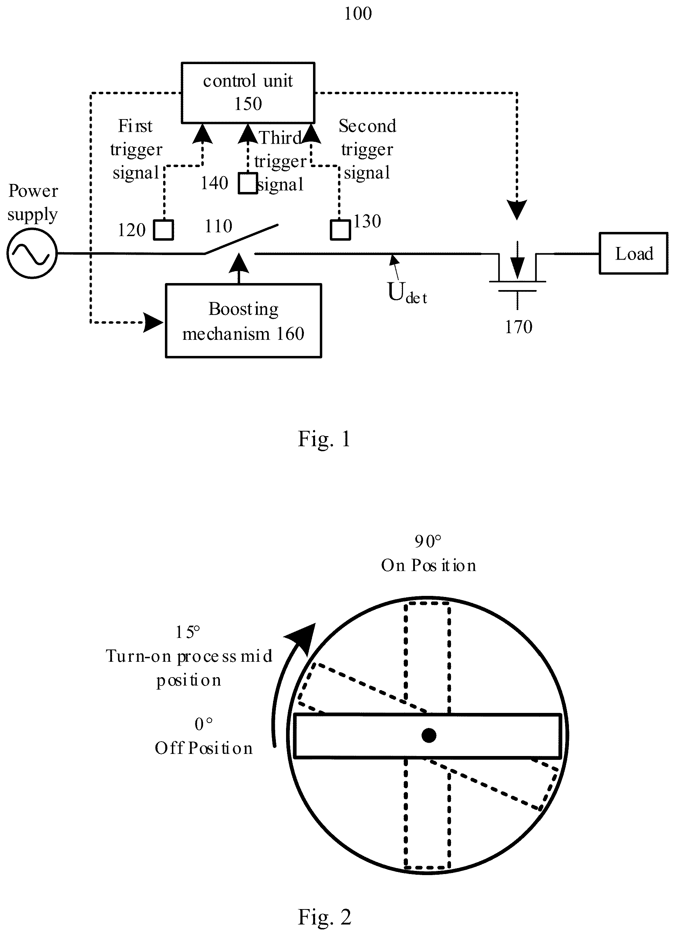

Fig. 1 schematically illustrates a circuit diagram of a solid-state circuit breaker 100 in accordance with an embodiment of the present disclosure. The solid-state circuit breaker 100 with a boost includes an electronic switch 170, a mechanical switch 110, one or more sensors (sensors 120, 130, and 140 are exemplarily shown in Fig. 1), a control unit 150, and a boosting mechanism 160. The electronic switch 170 and the mechanical switch 110 are connected in series and arranged on the power supply line from the power supply to the load. The mechanical switch 110 is configured to complete the turn-on process and the turn-off process through manual operation so that the load can be connected or disconnected from the power source. Sensors 120, 130, and 140 are configured to generate trigger signals based on the position of mechanical switch 110 during the turn-on process or the turn-off process. The control unit 150 is configured to activate the boosting mechanism 160 according to the trigger signal. The boosting mechanism 160 is configured to provide assistance or a boost for the turn-on process or the turn-off process of the mechanical switch 110.

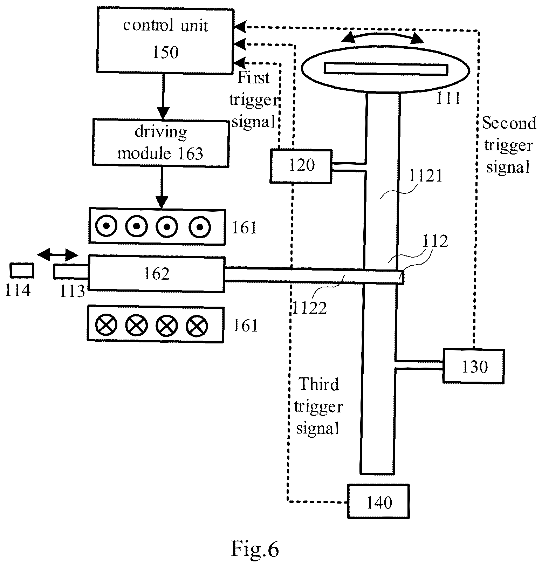

In embodiments according to the present disclosure, the boosting mechanism 160 may, in particular, be designed as an electromagnetic boosting mechanism. When energized, the electromagnetic boosting mechanism can move components mechanically associated with the mechanical switch 110, thereby providing assistance or boost for the turn-on/turn-off process of the mechanical switch 110. This is explained in detail later in the embodiment shown in Fig. 6.

Fig. 1 exemplarily illustrates a solid-state circuit breaker 100 in a single phase power supply line. Those skilled in the art can also apply the solid-state circuit breaker 100 to a three-phase power supply line or a DC power supply line.

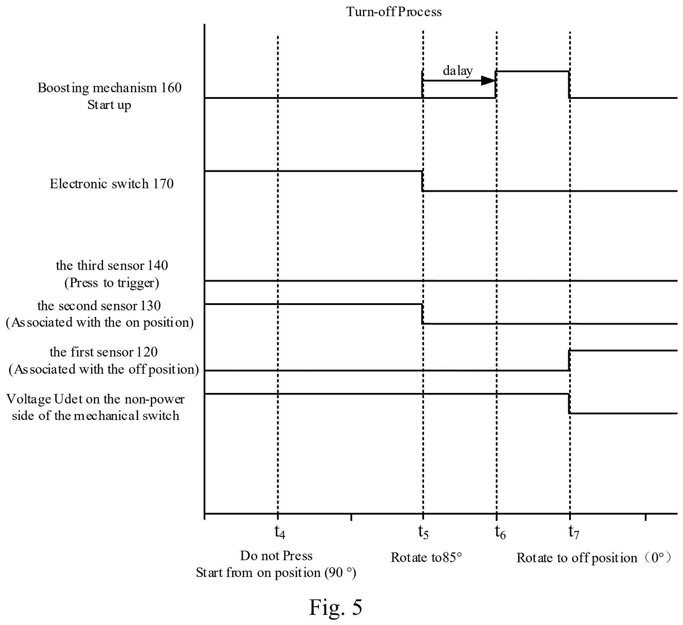

The electronic switch 170 may be, for example, a known electronic switch such as MOSFET or IGBT. When disconnecting the power supply line, it is necessary to first turn off the electronic switch 170 and then turn off the mechanical switch 110, which serves as an isolation function. The sequence of actions of the electronic switch 170 and the mechanical switch 110 is described in detail in Fig. 5.

In embodiments according to the present disclosure, the mechanical switch 110 can be configured as a knob or handle, for example. The mechanical switch 110 can be in an on position and an off position and can be in an intermediate position/mid position during manipulation, such as the turn-on process mid position and the turn-off process mid position mentioned below. In another embodiment, as shown in Fig. 6, the mechanical switch 110 may include, for example, a manual operating component 111, a transmission component 112, a movable contact 113 and a stationary contact 114. The manual operating component 111 can be configured as a knob, for example. The rotational movement of the manual operating component 111 is converted into a translational movement of the movable contact 113 via a transmission part 112, such as one or more transmission rods, thereby causing the movable contact 113 to come into contact with or separate from the stationary contact 114. Due to the mechanical coupling of the manual operating component 111, the transmission component 112 and the movable contact 113, their on positions correspond to each other, as do their off positions.

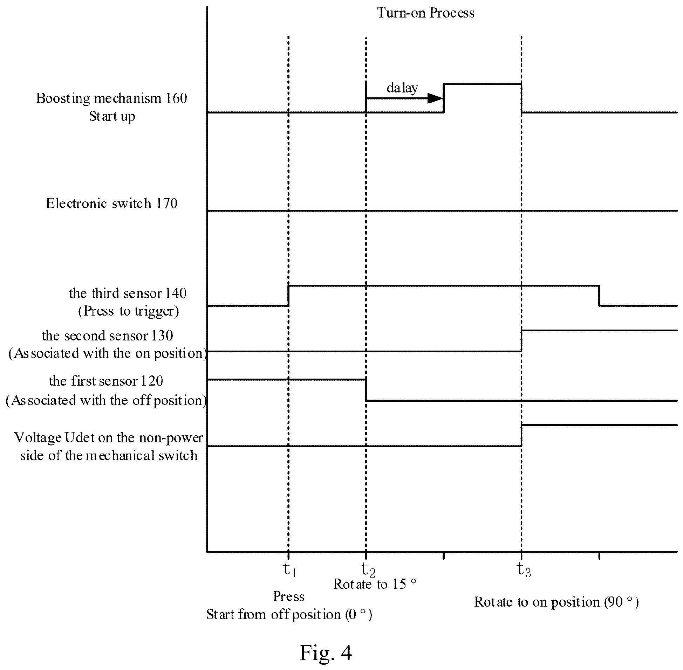

A mechanical switch 110 configured as a knob is exemplarily shown in Fig. 2 and 4. In particular, the manually operated components of the mechanical switch 110 are shown in Fig. 2 and 4. It should be noted that the on and off positions of the mechanical switch 110, its manual operating components and movable contacts according to the present disclosure correspond to each other.

Fig. 2 schematically illustrates a turn-on process of a mechanical switch 110 configured as a knob according to an embodiment of the present disclosure. During the turn-on process, the knob is twisted clockwise, starting from the on position (e.g. angle 0°) through the turn-off process mid position (e.g. angle 15°) to the off position (e.g. angle 90°).

One of the sensors, such as the first sensor 120, for example, can be configured to generate a first trigger signal in response to the mechanical switch (knob) reaching the turn-on process mid position (such as an angle of 15°). The control unit 150 is configured to activate the boosting mechanism 160 according to the first trigger signal. The boosting mechanism 160 provides an assist for the turn-on process so that the operator can more easily and quickly turn the knob to the on position, thereby shortening the duration of the intermediate process and preventing the mechanical switch from being intentionally or unintentionally stuck in the intermediate position.

In further embodiments according to the present disclosure, the mechanical switch may need to be pressed and twisted to achieve turning on. To this end, one of the sensors, such as the third sensor 140, can be configured to generate a third trigger signal in response to the mechanical switch being pressed. The control unit 150 may, for example, be configured to activate the boosting mechanism 160 according to the first trigger signal and the third trigger signal. In other words, the boosting mechanism 160 provides assistance or boost for manual operation of the mechanical switch only when the knob is pressed and twisted to a turn-on process mid position (for example, an angle of 15°).

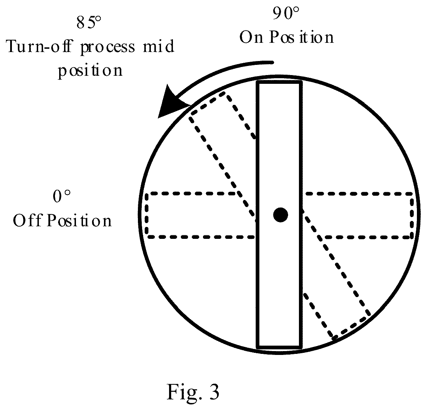

Fig. 3 schematically illustrates a turn-off process of a mechanical switch 110 configured as a knob in a solid-state circuit breaker 100 according to an embodiment of the present disclosure. During the turn-off process, the knob is twisted counterclockwise and starts from the on position (e.g. angle 90°) through the turn-off process mid position (e.g. angle 85°) to the off position (e.g. angle 0°).

One of the sensors, such as the second sensor 130, for example, can be configured to generate a second trigger signal in response to the mechanical switch (knob) reaching a turn-off process mid position (such as angle 85°). The control unit 150 is configured to activate the boosting mechanism 160 according to the second trigger signal. The boosting mechanism 160 provides assistance or boost for the turn-off process so that the operator can more easily and quickly turn the knob to the off position, thereby shortening the duration of the intermediate process and preventing the mechanical switch from being intentionally or unintentionally stuck in the intermediate position.

Fig. 4 schematically illustrates a timing diagram of a turn-on process of a solid-state circuit breaker according to an embodiment of the present disclosure. In this embodiment, the mechanical switch 110 is configured as a depressible knob. The operator presses the knob at time t1 and twists the knob clockwise starting from 0° (as shown in Fig. 2). The knob always remains pressed during the turn-on process, so the third sensor 140 always remains triggered (high level) starting from time t1, and thus generates a third trigger signal. The operator twists the knob to 15° at time t2, at which time it is assumed that the mechanical switch 110 leaves the off position, and the first sensor 120 (associated with the off position) is therefore triggered (from high level to low level), and thus generates the first trigger signal.

In an embodiment according to the present disclosure, at time t2, the control unit 150 sends a start signal to the boosting mechanism 160 according to the first trigger signal (triggering of the first sensor 120) and the third trigger signal (triggering of the third sensor 140). The boosting mechanism 160 can be immediately activated and provide an assistance or boost. In other embodiments, the boosting mechanism 160 can also be reactivated and provide assistance or boost after a delay. Fig. 4 shows a delayed start-up of the boosting mechanism 160.

Under the assistance of the boosting mechanism 160, the mechanical switch 110 is rotated to 90° at time t3. At this time, the mechanical switch 110 reaches the on position. The second sensor 130 (associated with the on position) is triggered, i.e. indicates that the on position has been reached. The assistance of the boosting mechanism 160 ends (becomes low level). Based on the conduction of the mechanical switch 110, the voltage Udet on the non-power supply side of the mechanical switch 110 becomes high level. At some time after time t3, the operator stops pressing the knob, and the third sensor 140 is no longer triggered and changes from high level to low level.

Fig. 5 schematically illustrates a timing diagram of a turn-off process of a solid-state circuit breaker in accordance with an embodiment of the present disclosure. The operator twists the knob in the counterclockwise direction starting at 90° at time t4 (as shown in Fig. 3). During disconnection, the operator does not need to press the knob, so the third sensor 140 is never triggered (remains low). The operator twists the knob to 85° at time t5, at which time it is assumed that the mechanical switch 110 leaves the on position, and the second sensor 130 (associated with the on position) is therefore triggered (from high level to low level), and thus generates a second trigger signal.

In an embodiment according to the present disclosure, at time t5, the control unit 150 first controls the electronic switch 170 to turn off according to the second trigger signal. Electronic switch 170 changes from high level to low level. The control unit 150 controls the boosting mechanism 160 to be started after a predetermined time interval, that is, with a delay. This is to ensure that the electronic switch 170 is successfully turned off before the mechanical switch 110 is opened. Because only the electronic switch 170 can open the circuit and cut off the current, the mechanical switch 110 itself cannot cut off the current. In an embodiment according to the present disclosure, the predetermined time interval can be set in the range of 3 ms to 10 ms, for example. Those skilled in the art can also extend or shorten the predetermined time interval according to actual conditions. As shown in Fig. 5, the trigger of the boosting mechanism 160 is delayed until time t6, at which time the knob can be in the range of 80° to 60°, for example.

In an embodiment according to the present disclosure, the control unit 150 may, for example, send a disconnection signal to the electronic switch 170 according to the second trigger signal, and detect whether the electronic switch is successfully disconnected. The detection can be achieved, for example, by detecting the voltage across the electronic switch 170. The control unit 150 activates the boosting mechanism 160 after a predetermined time interval in response to the electronic switch 170 being successfully turned off.

Under the assistance of the assistance mechanism 160, the mechanical switch 110 is rotated to 0° at time t7. The first sensor 120 (associated with the off position) is triggered, i.e. indicates that the off position has been reached. The assist of the boosting mechanism 160 ends (becomes low level). Based on the opening of the mechanical switch, the voltage Udet on the non-power supply side of the mechanical switch becomes low level.

In embodiments according to the present disclosure, the first sensor 120, the second sensor 130 and the third sensor 140 can be configured as micro switches, for example. The micro switches include a first micro switch, a second micro switch, and a third micro switch.

The first micro switch is associated with the off position of the mechanical switch 110. For example, when the mechanical switch 110 leaves the off position, the first micro switch generates the first trigger signal. The second micro switch is associated with the on position of the mechanical switch 110. For example, when the mechanical switch 110 moves away from the on position, the second micro switch generates the second trigger signal. In embodiments according to the present disclosure, for example, a predetermined stroke threshold or rotation angle threshold can be set. When the mechanical switch 110 deviates from the on position or the off position by more than the stroke threshold or rotation angle threshold, the micro switch may determine that the mechanical switch 110 leaves the on position or off position. The third micro switch is associated with the depression of the mechanical switch 110. For example, when the mechanical switch is depressed, the third micro switch generates a third trigger signal.

Fig. 6 schematically illustrates a structural diagram of the mechanical switch 110 and the boosting mechanism 160 in the solid-state circuit breaker 100 according to an embodiment of the present disclosure. The mechanical switch 110 includes a manual operating component 111, a transmission component 112, a movable contact 113 and a stationary contact 114. The manual operation part 111 can be configured as a knob shown in Fig. 2 and 3. The rotational movement of the manual operating component 111 is converted into a translational movement of the movable contact 113 via the transmission component 112, thereby causing the movable contact 113 to contact or separate from the stationary contact 114. In Fig. 6, the transmission component 112 includes a first transmission rod 1121 and a second transmission rod 1122. The first transmission rod 1121 is fixedly connected to the manual operating component 111 and performs rotational movement synchronously. The first transmission rod 1121 is coupled to the second transmission rod 1122 such that rotational movement of the first transmission rod 1121 causes translational movement of the second transmission rod 1122. The second transmission rod 1122 is fixedly connected to the movable contact 113, and the translational movement of the second transmission rod 1122 causes the translational movement of the movable contact 113, thereby causing the movable contact 113 to contact or separate from the stationary contact 114.

In the present disclosure, the solid-state circuit breaker 100 also includes a boosting mechanism 160. In the embodiment shown in Fig. 6, the boosting mechanism is designed as an electromagnetic boosting mechanism, which includes a coil 161 and an iron core 162. The coil 161 has a hollow cylindrical shape. The iron core 162 is arranged in the cavity of the coil 161. The iron core 162 is linked with the mechanical switch 110, in particular, fixedly connected with the second transmission rod 1122 of the mechanical switch 110. The magnetic field generated by the coil 161 can provide a boost or assistance for the translation movement of the second transmission rod 1122 and the movable contact 113.

The first sensor 120 and the second sensor 130 mentioned in the above embodiments of the present disclosure are fixedly connected to the first transmission rod 1121. The forward rotation of the manual operating component 111 (turn-on process) triggers the first sensor 120, and the reverse rotation of the manual operating component 111 (turn-off process) triggers the second sensor 130. The third sensor 140 mentioned in the above embodiment of the present disclosure is arranged at the free end of the first transmission rod 1121, and the pressing of the manual operating component 111 triggers the third sensor 140. The triggering mechanisms of the first sensor 120, the second sensor 130 and the third sensor 140 have been explained in detail in the embodiments shown in Fig. 2, 3, 4 and 5.

For example, during the turn-on process, the trigger signals of the first sensor 120 and the third sensor 140 are sent to the control unit 150. The control unit 150 controls the driving module 163 in the boosting mechanism 160 to generate a forward current, and the forward current generates a magnetic field along the first direction in the coil 161, which drives or provides a boost to the movable contact 113 to move to the left to contact the stationary contact 114. During the turn-off process, the trigger signal of the second sensor 130 is sent to the control unit 150. The control unit 150 controls the driving module 163 in the boosting mechanism 160 to generate a reverse current, and the reverse current generates a magnetic field along the second direction in the coil 161, which drives or provides a boost to the movable contact 113 to move to the right and separate from the stationary contact 114.

The block diagrams of circuits, units, devices, devices, equipment, and systems involved in this disclosure are only illustrative examples and are not intended to require or imply that they must be connected, arranged, or configured in the manner shown in the block diagrams. As those skilled in the art will recognize, these circuits, units, devices, devices, equipment, systems can be connected, arranged, and configured in any way as long as the desired purpose is achieved. The circuits, units, devices, and devices involved in the present disclosure can be implemented in any suitable manner, such as an application-specific integrated circuit, a field programmable gate array (FPGA), etc., or a general-purpose processor combined with a program.

Those skilled in the art should understand that the above-mentioned specific embodiments are only examples and not limitations. Various modifications, combinations, partial combinations and substitutions can be made to the embodiments of the present disclosure according to design requirements and other factors, as long as they are within the scope of the appended claims or their equivalents, they belong to the scope of rights to be protected by this disclosure.

## Claims

1. A solid-state circuit breaker (100), the solid-state circuit breaker (100) comprising:
an electronic switch (170);
a mechanical switch (110) configured to complete a turn-on process and a turn-off process by manual operation;
a sensor (120, 130, 140) configured to generate a trigger signal depending on a position of the mechanical switch (110) during at least one of the turn-on process or the turn-off process; and
a control unit (150) configured to activate a boosting mechanism (160) according to the trigger signal;
wherein the boosting mechanism (160) is configured to provide a boost for the at least one of the turn-on process or the turn-off process; and
wherein the electronic switch (170) is connected in series with the mechanical switch (110).

2. The solid-state circuit breaker (100) of claim 1, wherein:
the mechanical switch (110) starts from an off position through a turn-on process mid position to an on position;
the sensor (120, 130, 140) comprises a first sensor (120);
the first sensor (120) is configured to generate a first trigger signal in response to the mechanical switch (110) reaching the turn-on process mid position; and
the control unit (150) is configured to activate the boosting mechanism (160) according to the first trigger signal.

3. The solid-state circuit breaker (100) of claim 1 or claim 2, wherein:
the mechanical switch (110) starts from the on position through a turn-off process mid position to the off position;
the sensor (120, 130, 140) comprises a second sensor (130);
the second sensor (130) is configured to generate a second trigger signal in response to the mechanical switch (110) reaching the turn-off process mid position; and
the control unit (150) is configured to activate the boosting mechanism (160) according to the second trigger signal.

4. The solid-state circuit breaker (100) of claim 3, wherein:
the control unit (150) is configured to control the turn-off of the electronic switch (170) according to the second trigger signal and activate the boosting mechanism (160) after a predetermined time interval.

5. The solid-state circuit breaker (100) of claim 4, wherein:
the control unit (150) is configured to control the turn-off of the electronic switch (170) according to the second trigger signal by:
sending a turn-off signal to the electronic switch (170) according to the second trigger signal, and detecting whether the electronic switch (170) is successfully turned off; and
activating the boosting mechanism (160) after a predetermined time interval in response to the electronic switch (170) being successfully turned off.

6. The solid-state circuit breaker (100) of claim 4 or claim 5, wherein the predetermined time interval is set in the range of 3 ms to 10 ms.

7. The solid-state circuit breaker (100) of claim 2 or any of claims 3 to 6 when dependent on claim 2, wherein:
the mechanical switch (110) is configured as a depressible knob;
the sensor (120, 130, 140) comprises a third sensor (140);
the third sensor (140) is configured to generate a third trigger signal in response to the mechanical switch (110) being depressed; and
the control unit (150) is configured to activate the boosting mechanism (160) according to the first trigger signal and the third trigger signal.

8. The solid-state circuit breaker (100) of claim 2 or any of claims 3 to 7 when dependent on claim 2, wherein:
the first sensor (120) is configured as a first micro switch;
the first sensor (120) generating a first trigger signal in response to the mechanical switch (110) reaching the turn-on process mid position by the first micro switch generating the first trigger signal in response to the mechanical switch (110) moving away from the off position.

9. The solid-state circuit breaker (100) of claim 3 or any of claims 4 to 8 when dependent on claim 3, **characterized in that**
the second sensor (120, 130, 140) is configured as a second micro switch;
the second sensor (120, 130, 140) generating a second trigger signal in response to the mechanical switch (110) reaching the turn-off process mid position by the second micro switch generating the second trigger signal in response to the mechanical switch (110) moving away from the on position.

10. The solid-state circuit breaker (100) of any of claims 1 to 9, wherein the boosting mechanism (160) is an electromagnetic boosting mechanism (160) comprising a coil (161) and an iron core (162);
the iron core (162) is linked with the mechanical switch (110);
the control unit (150) is configured to control the direction of current flowing through the coil (161) depending on the trigger signal; and
the iron core (162) provides a boost to the turn-on process in response to a positive current flowing in the coil, and provides a boost to the turn-off process in response to a negative current flowing in the coil.

11. The solid-state circuit breaker (100) of any of claims 1 to 10, wherein the mechanical switch (110) comprises a manually operated component, a transmission component, a moving contact, and a stationary contact.
